# EUROPEAN PATENT SPECIFICATION

(11) **EP 2 562 195 B1**
(45) Date of publication and mention of the grant of the patent: **20.06.2018**
(21) Application number: 11771750.4
(22) Date of filing: 19.04.2011
(51) Int. Cl.: C08G 59/62, C08G 59/50, C08J 5/24, C08L 63/00, H05K 1/03

(54) **EPOXY RESIN COMPOSITION, PREPREG, METAL-CLAD LAMINATE, AND PRINTED WIRING BOARD**
EPOXIDHARZZUSAMMENSETZUNG, PREPREG, METALLKASCHIERTES LAMINAT UND BESTÜCKTE LEITERPLATTE
COMPOSITION DE RÉSINE ÉPOXYDE, PRÉIMPRÉGNÉ, STRATIFIÉ À REVÊTEMENT MÉTALLIQUE ET CARTE IMPRIMÉE

(30) Priority: 27.09.2010 JP 2010215999; 23.04.2010 JP 2010099879
(43) Date of publication of application: 27.02.2013
(73) Proprietor: Panasonic Intellectual Property Management Co., Ltd., Osaka-shi, Osaka 540-6207 (JP)
(72) Inventor: YAMAGUCHI, Mao, Chuo-ku, Osaka 540-6207 (JP); ARISAWA, Tatsuya, Chuo-ku Osaka 540-6207 (JP); ARAKI, Syunji, Chuo-ku Osaka 540-6207 (JP); KASHIHARA, Keiko, Chuo-ku Osaka 540-6207 (JP); SAGARA, Takashi, Chuo-ku Osaka 540-6207 (JP); LIN, Lin, Chuo-ku Osaka 540-6207 (JP)
(74) Representative: Appelt, Christian W.
(86) International application number: PCT/JP2011/002292
(87) International publication number: WO 2011/132408

(56) References cited:
- EP-A1- 2 537 853
- WO-A1-2009/070488
- WO-A2-2010/114279
- JP-A- 3 054 219
- JP-A- 2003 206 392
- JP-A- 2007 196 561

## Description

### Technical Field

The present invention relates to an epoxy resin composition including substantially no halogens, and more particularly to an epoxy resin composition that can be advantageously used as an insulating material for a printed wiring board or the like. The present invention also relates to a prepreg, a metal-clad laminate, and a printed wiring board using such epoxy resin composition.

### Background Art

Epoxy resin compositions are widely used as printed wiring board materials because of excellent adhesiveness, electric insulating properties, and chemical resistance.

WO 2010/114279 A2 describes phosphorus-containing phenol novolac resin, use of the phosphorus-containing phenol novolac resin as a halogen-free flame retardant epoxy hardener, and an epoxy resin composition having high phosphorus content because it includes the phosphorus-containing phenol novolac resin.

EP 2 537 853 A1 describes a phosphorus-containing oligomer that has high solubility in a solvent and exhibits high flame retardancy and heat resistance in the form of a cured product thereof, a method for producing the phosphorus-containing oligomer, a curable resin composition that uses the oligomer as a curing agent for epoxy resins, a cured product of the curable resin composition, and a printed wiring board that uses the curable resin composition.

WO 2009/070488 A1 describes the elimination of toxic and high boiling solvents, such as DMF, NMP, and DMSO, in epoxy formulations where dicyandiamide is used as a curing agent. Described therein are hardener compositions and cured resins that are formed from such curable compositions, where the hardener compositions include an epoxy resin, dicyandiamide, and a phosphorus-containing phenolic hardener.

Since epoxy resins have comparatively poor flame resistance, halogen flame retardants such as bromine flame retardants or halogen flame retardants demonstrating excellent effect in imparting flame resistance, such as halogen-containing epoxy resin, for example, tetrabromobisphenol A epoxy resins, are typically compounded with the epoxy resin compositions used for printed wiring boards. However, the products obtained by curing such epoxy resin compositions including halogens can generate hazardous substances such as hydrogen halides during burning and can adversely affect people and natural environment.

For example, it is known to use an epoxy resin compounded with a phosphorus compound instead of the halogen flame retardant in order to resolve this problem (for example, Patent Document 1).

Patent Document 1: Japanese Patent Application Publication No. 2007-326929

However, in the laminates using a phosphorus-containing epoxy resin that is compounded with a phosphorus compound, the concentration of phosphorus is as low as 2% to 3%, and it is necessary to use a curing agent with a low equivalent amount, such as dicyandiamide, and increase the epoxy component ratio to ensure flame resistance. The resultant problem is that heat resistance of the obtained laminate is insufficient and defects such as delamination often occur during reflowing with the presently available lead-free solders. Accordingly, a demand has been created for halogen-free epoxy resin composition with superior heat resistance.

### Summary of the Invention

It is an object of the present invention to provide an epoxy resin composition that makes it possible to obtain a substrate that maintains flame resistance even without introducing a halogen flame retardant into the epoxy resin composition and has heat resistance adequate for lead-free soldering, and also to provide a prepreg obtained from such composition and a metal-clad laminate and a printed wiring board that are provided with a resin insulating layer formed from the composition.

The inventors have conducted a comprehensive study aimed at the resolution of the aforementioned problem and have found that the problem can be resolved by the following means.

Thus, the present invention provides an epoxy resin composition including: (A) a polymerized compound including, as structural components, phosphaphenanthrene and at least one constituent selected from a structural unit of a phenolic novolak polymer and a structural unit of a phenolic novolak polymer in which a hydrogen atom of a phenolic hydroxyl group is substituted by phosphaphenanthrene; (B) an epoxy resin having two or more epoxy groups in a molecule; and (C) a curing agent that cures the epoxy resin, wherein the curing agent is a phenolic novolak curing agent with a softening point equal to or lower than 120°C; characterized in that a phenolic novolak curing agent with a softening point equal to or lower than 105°C and a phenolic novolak curing agent with a softening point of 105°C to 120°C are used together as the curing agent and also a prepreg obtained from such composition, and a metal-clad laminate and a printed wiring board that are provided with a resin insulating layer formed from the composition.

The present invention can provide an epoxy resin composition that can be used for a substrate that maintains flame resistance even without containing a halogen flame retardant and has heat resistance adequate for lead-free soldering and excellent dimensional stability. The present invention can also provide a prepreg obtained from such composition, a metal-clad laminate and a printed wiring board that are provided with a resin insulating layer formed from the composition.

### Description of Embodiments

### (Epoxy Resin Composition)

The epoxy resin composition in accordance with the present invention includes: (A) a polymerized compound including, as structural components, phosphaphenanthrene and at least one constituent selected from a structural unit of a phenolic novolak polymer and a structural unit of a phenolic novolak polymer in which a hydrogen atom of a phenolic hydroxyl group is substituted by phosphaphenanthrene; (B) an epoxy resin having two or more epoxy groups in a molecule; and (C) a curing agent that cures the epoxy resin, wherein the curing agent is a phenolic novolak curing agent with a softening point equal to or lower than 120°C; characterized in that a phenolic novolak curing agent with a softening point equal to or lower than 105°C and a phenolic novolak curing agent with a softening point of 105°C to 120°C are used together as the curing agent.

The polymerized compound including, as structural components, "phosphaphenanthrene" and "at least one constituent selected from a structural unit of a phenolic novolak polymer and a structural unit of a phenolic novolak polymer in which a hydrogen atom of a phenolic hydroxyl group is substituted by phosphaphenanthrene" in accordance with the present invention is obtained, for example, by polymerizing phosphaphenanthrene such as 9,10-dihydro-9-oxa-10-phosphaphenanthrene-10-oxide (also referred to as HCA hereinbelow) or a derivative thereof and a phenolic novolak polymer and/or a phenolic novolak polymer in which a hydrogen atom of a phenolic hydroxyl group is substituted by phosphaphenanthrene.

For example, EXB9150 and EXB9152 (manufactured by DIC Corp.) having a structure represented by Chemical Formula (1) below can be procured as the commercial products of such polymerized compound. 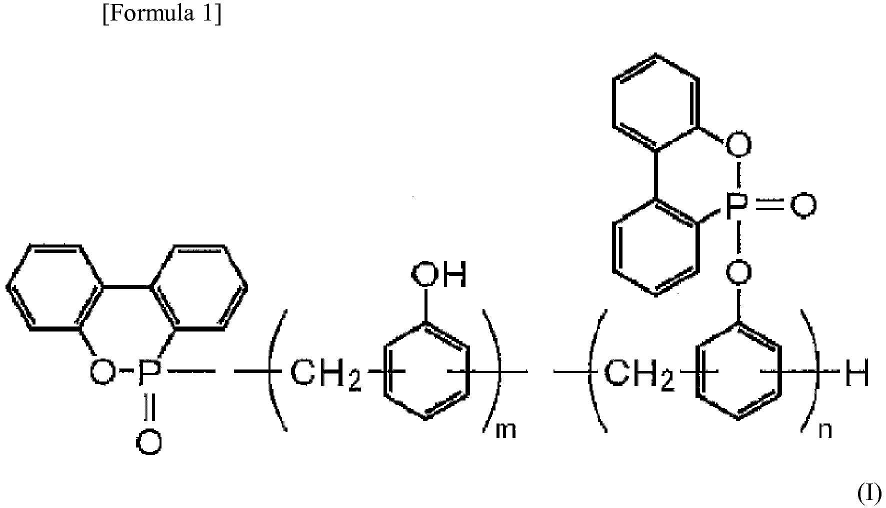 (in the formula, m is 0 to 3; n is 0 to 6; however, m and n are not 0 at the same time).

In the epoxy resin composition in accordance with the present invention, the content ratio of phosphorus in the polymerized compound that is the component (A) is preferably 10 wt% to 12 wt%, more preferably 10.5 wt% to 11 wt%. Where the content ratio of phosphorus is less than 10 wt%, an epoxy resin composition for substrates having sufficient heat resistance and flame resistance cannot be obtained. It is also undesirable that the content ratio of phosphorus be above 12 wt% because the reactivity of the polymerized compound that is the component (A) with epoxy decreases and the glass transition temperature (Tg) tends to decrease.

The content ratio of the component (A) in the epoxy resin composition in accordance with the present invention is usually 5 wt% to 30 wt%, preferably 10 wt% to 20 wt%, based on the total weight of the epoxy resin composition.

Any epoxy resin can be used, without any particular limitation, as the epoxy resin (B) having two or more epoxy groups in a molecule, provided that the epoxy resin has two or more epoxy groups in a molecule and the effect of the present invention is not adversely affected.

Specific examples of suitable epoxy resins include bisphenol A epoxy resins, cresol novolak epoxy resins, bisphenol E epoxy resins, phenolic novolak epoxy resins, dicyclopentadiene epoxy resins, biphenyl epoxy resins, naphthalene epoxy resin, and phenolic aralkyl epoxy resins. Those epoxy resins may be used individually or in combinations of two or more thereof. Among them, bisphenol A epoxy resins and cresol novolak epoxy resins can be used particularly advantageously.

The epoxy equivalent of the epoxy resin of the component (B) is preferably 150 to 500 on average.

The content ratio of the component (B) in the epoxy resin composition in accordance with the present invention is preferably 40 wt% to 90 wt%, more preferably 50 wt% to 70 wt%, based on the total weight of the epoxy resin composition.

As the curing agent, the epoxy resin composition in accordance with the present invention also includes a curing agent (C) that can cure the epoxy resin. The curing agent is not particularly limited, provided that the epoxy resin can be cured. Examples of suitable curing agents include amine curing agents and phenolic curing agents.

From the standpoint of increasing the heat resistance of the cured prepreg, it is preferred that a phenolic curing agent be used. Specific examples of phenolic curing agents include phenolic novolak resins, phenolic aralkyl resins, bisphenol A novolak resins, cresol novolak resins, and naphthol aralkyl resins. Among them, from the standpoint of obtaining a higher heat resistance, it is preferred that a phenolic novolak resin be used as the curing agent. The abovementioned curing agents may be used individually or, as necessary, in combinations of two or more thereof.

By using a phenolic novolac curing agent with a softening point equal to or lower than 120°C, more preferably a phenolic novolac curing agent with a softening temperature equal to or lower than 105°C, it is possible to reduce the ΔTg, which is used as an index for evaluating the degree of curing of the molded laminate. By reducing the ΔTg, it is possible to provide a laminate with better heat resistance and dimensional stability.

However, where a phenolic novolak curing agent with a low softening point is used, it is possible that the Tg (below-described Tg₂) will be reduced too much. Therefore, a phenolic novolak curing agent with a softening temperature equal to or lower than 105°C and a phenolic novolac curing agent with a softening temperature of 105°C to 120°C. No particular limitation is placed on the ratio of the two curing agents, but usually a phenolic novolak curing agent with a softening temperature equal to or lower than 105°C and a phenolic novolac curing agent with a softening temperature of 105°C to 120°C are used together at a solid fraction ratio thereof of 1:9 to 9:1, more preferably 5:5. The "solid fraction" as referred to herein is a weight after the solvent fraction has been removed.

The Tg₁ is the initial glass transition temperature observed when the pretreated laminate is heated to 220°C, the Tg₂ is the second glass transition temperature observed when the laminate is thereafter cooled and reheated to 220°C, and the ΔTg is a value indicating the difference between the Tg₁ and the Tg₂ (ΔTg = Tg₂ - Tg₁). The detailed measurements method can be based, for example, on the method disclosed in the below-described examples. A large value of ΔTg thus obtained indicates the presence of a large amount of unreacted components and therefore means that the molded laminate has degraded heat resistance and dimensional stability.

The softening point of the phenolic novolak curing agent is not particularly limited, provided that it is equal to or lower than 120°C, but since the Tg can be too low, it is preferred that the softening point be equal to or higher than 60°C. It is even more preferred that the softening point of the phenolic novolak curing agent be equal to or lower than 100°C.

From the standpoint of obtaining excellent heat resistance and good adhesion between the prepreg and a copper foil, it is preferred that an amine curing agent be used. Specific examples of amine curing agents include dicyandiamide, aliphatic amine curing agents, alicyclic amine curing agents, aromatic amine curing agents, polyamidoamine curing agents, and organic acid dihydrazides. Among them, dicyandiamide is preferred.

Concerning the compounding amount of the component (C), when a phenolic novolak curing agent is used, the compounding amount thereof is 5 wt% to 50 wt%, more preferably 20 wt% to 40 wt%, on the basis of the total weight of the epoxy resin composition.

When an amine curing agent is used, the compounding amount thereof is 0.1 wt% to 20 wt%, preferably 0.5 wt% to 10 wt%, on the basis on the total weight of the epoxy resin composition.

It is also preferred that the epoxy resin composition in accordance with the present invention include a curing accelerator for accelerating the curing reaction in addition to the above-described necessary components (A) to (C). Any curing accelerator can be used without any particular limitation, provided that it can accelerate the curing reaction of the above-described epoxy resin components and curing agent (C). Specific examples include imidazoles such as 2-methylimidazole and cyanoethylimidazole, metallic soaps such as zinc octanoate, copper naphthenate, and cobalt naphthenate, organophosphorus compounds such as triphenylphosphine, amine compounds such as triethylamine, and 1,8-diazabicyclo[5. 4. 0]undene-7. Those compounds may be used individually or in combinations of two or more thereof. From the standpoint of increasing the reactivity of the polymerized compound, which is the component (A), and the epoxy resin and increasing the adhesiveness, it is preferred that a combination of an imidazole and a metallic soap be used.

When the curing accelerator is included in the present invention, it is preferred that the compounding amount thereof be about 0.01 wt% to 3 wt%, on the basis of the entire weight of the epoxy resin composition.

If necessary, the epoxy resin composition in accordance with the present invention may also include other additives within ranges in which the effect of the present invention is not lost, examples of such additives including flame retardants, flame resistance enhancers, leveling agents, and colorants. It is preferred that a flame retardant such as condensed phosphoric acid ester be included in the epoxy resin composition in accordance with the present invention at a content ratio of 1 wt% to 20 wt%, on the basis of the total weight of the epoxy resin composition. Examples of suitable condensed phosphoric acid esters include aromatic condensed phosphoric acid esters such as resorcinol bis(dixylenyl phosphate) (PX200), bisphenol A bis(diphenyl phosphate), and resorcinol bis(diphenyl phosphate).

The epoxy resin composition in accordance with the present invention is usually prepared and used in the form of varnish. The varnish is prepared, for example, in the following manner.

Thus, a varnish-like composition can be prepared by compounding an organic solvent with the above-described components of the epoxy resin composition, adding an inorganic filler, as necessary, and uniformly dispersing and mixing by using a ball mill, a beads mill, a mixer, or a blender.

The organic solvent is not particularly limited. Examples of suitable solvents include aromatic hydrocarbons such as benzene and toluene, amides such as N,N-dimethylformamide (DMF), ketones such as acetone and methyl ethyl ketone, alcohols such as methanol and ethanol, and cellosolve. Those solvents may be used individually or in combinations of two or more thereof.

### (Prepreg)

The prepreg in accordance with the present invention is obtained by impregnating a fibrous substrate with the above-described varnish-like epoxy resin composition.

More specifically, for example, the fibrous substrate is initially impregnated with the varnish-like resin, e.g., by dipping the fibrous substrate into the varnish-like resin. The impregnation is performed by dipping, coating, or the like. If necessary, the impregnation can be repeated a plurality of times. In this case, it is possible to repeat the impregnation by using a plurality of solutions that differ in composition and concentration and adjust to the final desirable composition and resin amount.

The fibrous substrate is not particularly limited, but it is preferred that a sheet-shaped fibrous substrate be used. Examples of suitable substrates include cloth or nonwoven fabric including inorganic fibers such as glass fibers, aramide cloth, polyester cloth, and paper. Typically, the substrate with a thickness of 0.02 mm to 0.2 mm can be used.

The substrate impregnated with the varnish-like epoxy resin composition is then heated and dried under the desirable heating conditions (for example, for 3 min to 10 min at 100°C to 180°C) to remove the solvent and semi-cure (transition to stage B) the resin components, thereby producing a prepreg. The amount of resin in the prepreg is preferably 30 wt% to 80 wt%, on the basis of the entire weight of the prepreg.

### (Metal-Clad Laminate)

A method for fabricating a metal-clad laminate by using the prepreg obtained in the above-described manner can include the steps of using a single prepreg or a stack of a plurality of prepregs, placing a metal foil such as a copper foil on one or each side thereof, and performing hot-press molding to integrate into a laminate, thereby producing a laminate clad with a copper foil on one or each side. The hot pressing conditions can be set, as appropriate, according to the thickness of the manufactured laminate or the type of the resin composition in the prepreg. For example, the hot pressing can be performed for 30 min to 240 min at a temperature of 150°C to 250°C and under a pressure of 1 Pa to 5 Pa.

When the inner layer is laminated, it is preferred that a multi-bond treatment or a black oxide treatment be performed in order to increase the adhesiveness of the prepreg used. The multi-bond treatment and black oxide treatment are performed by the usually used methods. More specifically, the multi-bond treatment is usually performed by roughening the surface of the copper foil of the inner layer with a copper roughening etching solution of a sulfuric acid/hydrogen peroxide system, and the black oxide treatment usually involves immersing into an alkaline aqueous solution including a chlorite as the main component to form a cupric oxide film.

### Examples

### (Multilayer Printed Wiring Board)

A printed wiring board in which a conductive pattern is provided as an electric circuit on the surface of the laminate can be obtained by etching the metal foil on the surface of the laminate obtained in the above-described manner to form the circuit.

The printed wiring board thus obtained excels in heat resistance adequate for lead-free soldering and demonstrates sufficient flame resistance even without containing a halogen flame retardant.

Specific examples of the present invention are described below in greater detail. However, the present invention is not limited to those examples.

Starting materials used in the examples are described below.

### <Polymerized Compound>

- Component (A): EXB9150, manufactured by DIC Corp. (phosphorus concentration 10.5%)
- Component (A): EXB9152, manufactured by DIC Corp. (phosphorus concentration 10.4%)
- 9,10-dihydro-10-(2,5-dihydroxyphenyl)-9-oxa-10-phosphaphenanthrene-10-oxide (HCA-HQ): HCA-HQ manufactured by Sanko Chemical Co., Ltd. (phosphorus concentration 9.6%)
- Polymerized composition of phosphaphenanthrene and a phenolic novolak epoxy: FX289, manufactured by Tohto Kasei Co., Ltd. (phosphorus concentration 2.2%) <Epoxy Resin Composition>
- Component (B) (bifunctional epoxy resin): EPICLON 850S (bisphenol A liquid epoxy resin, epoxy equivalent 190), manufactured by DIC Corp.
- Cresol novolak epoxy: N-690 (cresol novolak epoxy resin, epoxy equivalent 215), manufactured by DIC Corp.

### <Curing Agent Component>

- Component (C) curing agent (phenolic novolak resin): TD2090 (softening point 120°C), manufactured by DIC Corp.
- Component (C) curing agent (phenolic novolak resin): TD2093Y (softening point 100°C), manufactured by DIC Corp.
- Component (C) curing agent (phenolic novolak resin): TD2131 (softening point 80°C), manufactured by DIC Corp.
- Dicyandiamide curing agent: Dicyandiamido (registered trade name) (melting point 208°C) manufactured by Nippon Carbide Industries Co., Inc.

### <Curing Accelerator>

- Cyanoethylimidazole: 2E4MZ, manufactured by Shikoku Chemicals Corp.
- Metallic soap: zinc octanoate, manufactured by DIC Corp.

### <Flame Retardant>

- Condensed phosphoric acid ester: PX-200, manufactured by Daihachi Chemical Industry Co., Ltd.

### (Examples 1 to 6 not according to the invention and Comparative Examples 1 to 4)

Epoxy resin varnishes with a content of solids of 65 wt% to 75 wt% were prepared by adding methyl ethyl ketone and methoxypropanol to the compositions (parts by weight) shown in Table 1.

Glass cloth (WEA7628, manufactured by Nitto Boseki Co., Ltd.) was dipped into the resin varnish, the glass cloth was impregnated with the resin varnish, and then heating and drying were performed for 6 min to 8 min at 150°C to 160°C to remove the solvent and semi-cure (transition to stage B) the resin components, thereby producing a prepreg. The amount of resin in the prepreg was 40 wt% to 45 wt%, on the basis of the entire weight of the prepreg.

Four sheets of manufactured prepregs were stacked, a copper foil (GT-MP, manufactured by Furukawa Circuit Foil Co., Ltd.) with a thickness of 35 µm was laid on each side of the stack to obtain a body to be pressed, and then heating and pressing were performed for 100 min at a temperature of 180°C and under a pressure of 3 MPa (megapascal) to obtain a copper-clad laminate with a thickness of 0.8 mm in which a copper foil was bonded to each side.

A circuit was then formed by etching the copper foil on the surface of the obtained copper-clad laminate, and an inner layer treatment was performed by the multi-bond treatment and black oxide treatment. Thereon, the prepregs were laid one on each surface (upper and lower). Next, copper foils with a thickness of 35 µm were laid one on each prepreg to obtain a body to be pressurized, and then heating and pressing were performed for 100 min at a temperature of 180°C and under a pressure of 3 MPa (megapascal) to obtain a molded body in which copper foils were bonded to each surface. A four-layer printed wiring board was obtained by etching the copper foil on the surface.

The prepreg, metal-clad laminate, and printed wiring board obtained in the above-described manner were used as evaluation samples, and the flame resistance (laminate), interlayer adhesive strength, heat resistance in PCT soldering, and reflow heat resistance were evaluated as described below. The results are shown in Table 1. (not according to the invention).

### [Flame resistance (average burning time)]

A test piece with a length of 125 mm and a width of 12.5 mm was cut out after the copper foils of the copper-clad laminate have been removed. A burning test of the test piece was then performed according to the "Test for Flammability of Plastic Materials UL 94" of the Underwriters Laboratories, and the evaluation was performed by using an average burning time (seconds). When no anti-inflammation action was demonstrated, the evaluation was "Completely burned down".

### [Interlayer adhesive strength]

A peel strength between the first glass cloth and the second glass cloth of the copper-clad laminate was measured according to JIS C 6481. A pattern with a width of 10 mm and a length of 100 mm was formed, peeling was performed with a tension test machine at a rate of 50 mm/min, and a peel strength in this process was measured.

### [Heat resistance in PCT soldering]

Test pieces with a length of 50 mm and a width of 50 mm were cut out after the copper foils of the copper-clad laminate have been removed. The test pieces were loaded for 4 h and 6 h into a pressure cooker test (PCT) machine with a temperature of 121°C, a pressure of 2 atm, and a humidity of 100%. The test pieces were then dipped for 20 s into a solder bath at 260°C, and the evaluation was OK when neither measling nor bulging was observed.

### [Reflow heat resistance]

The obtained four-layer printed wiring board was loaded for 240 h into a 85°C-85% constant temperature and humidity container and then into a reflow furnace under a condition of the peak temperature of 260°C within a period equal to or longer than 10 s. Loading into the reflow furnace was repeated 10 times. Where neither measling nor bulging was observed, the evaluation was "Good", when measling was observed, the evaluation was "Fair", and when bulging or bulging and measling were observed, the evaluation was "Poor".

**[Table 1]**

| Table of Examples | | | | | | | | | | | | |
|---|---|---|---|---|---|---|---|---|---|---|---|---|
| Contents | Trade name | Phosphorus conc. | Example 1 | Example 2 | Example 3 | Example 4 | Example 5 | Example 6 | Comp. Example 1 | Comp. Example 2 | Comp. Example 3 | Comp. Example 4 |
| Polymerized compound of phosphaphenanthrene and phenolic novolak | EXB9150 | 10.5% | 15 | 15 | 15 | 15 | 15 | 15 | | | | |
| Cresol novolak epoxy | N690 | - | 40 | 40 | 40 | 62 | 62 | 62 | 40 | | 45 | |
| Bifunctional epoxy | 850S | - | 20 | 20 | 20 | 20 | 20 | 20 | 20 | | 25 | |
| Phenolic novolak curing agent | TD2090 | - | 25 | 25 | 25 | | | | 23 | | 30 | 25 |
| Dicyandiamide curing agent | DICY | - | | | | 3 | 3 | 3 | | 3 | | |
| Polymerized compound of phosphaphenanthrene and phenolic novolak epoxy | FX289 | 2.2% | | | | | | | | 97 | | 75 |
| HCA-HQ | HCA-HQ | 9.6% | | | | | | | 17 | | | |
| Imidazole | 2E4MZ | - | 0.05 | 0.05 | 0.05 | 0.05 | 0.05 | 0.05 | 0.05 | 0.05 | 0.05 | 0.05 |
| Metallic soap | Zinc octanoate | - | | 1 | 1 | | 1 | 1 | | | | |
| Condensed phosphoric acid ester | PX200 | 9.0% | | | 5 | | | 5 | | | | |
| Phosphorus concentration | | | 1.6% | 1.6% | 2.0% | 1.6% | 1.6% | 2.0% | 1.6% | 2.1% | 0% | 1.6% |
| Flame resistance (average burning time) | | | 4 | 4 | 2 | 4 | 4 | 2 | HCA-HQ solvent solubility is poor, uniform resin composition is not obtained | 3 | Completely burned down | 6 |
| Oven heat resistance | | | 280 | 280 | 270 | 250 | 250 | 240 | | 260 | 275 | 275 |
| Interlayer adhesiveness | | | 1.0 | 1.3 | 1.2 | 1.0 | 1.2 | 1.2 | | 1.4 | 1.3 | 1.4 |
| Heat resistance in PCT soldering | | | 4hOK | 6hOK | 6hOK | 4hOK | 6hOK | 6hOK | | 6hOK | 6hOK | 6hOK |
| Reflow heat resistance | Multi-bond treatment | | Good | Good | Good | Good | Good | Good | | Poor | Good | Good |
| | Black oxide treatment | | Fair | Fair | Fair | Good | Good | Good | | Poor | Fair | Fair |

### (Results)

The results shown in Table 1 indicate that the laminates of Examples 1 to 6 all have an average burning time of 2 s to 4 s (V-0 (equal to or less than 5 s) according to the UL standard) and demonstrate excellent flame resistance even without containing a halogen flame retardant. Further, good reflow heat resistance under a temperature condition equal to or higher than 260°C that is adequate for lead-free soldering was demonstrated by the printed wiring boards in all of the examples.

In particular, even better heat resistance in PCT soldering was demonstrated in the case of Examples 2 and 3 in which a metallic soap (zinc octanoate) was used as a curing accelerator.

In the case of Example 3 using a condensed phosphoric acid ester as a flame retardant, a higher flame resistance was demonstrated, while maintaining adhesiveness, soldering heat resistance, and reflow heat resistance.

Further, in Examples 4 to 6 using an amine curing agent, excellent reflow heat resistance was demonstrated with respect to either type of internal layer treatment. In Examples 1 to 3 using a phenolic novolak curing agent, a higher reflow heat resistance was obtained in the case of the multi-bond treatment.

On the other hand, in Comparative Example 1 in which HCA-HQ (phosphorus concentration 9.6 wt%) was used instead of the polymerized compound (A) in accordance with the present invention, the HCA-HQ solvent solubility was poor and a homogeneous resin composition could not be obtained. This was apparently because the reaction between the phenolic novolak, which was the curing agent, and epoxy ended before the HCA-HQ reacted with the epoxy, and the unreacted HCA-HQ remained in the system. Further, since the undissolved HCA-HQ was not impregnated when the prepreg was fabricated, the compounded amount of HCA-HQ in the actually obtained prepreg was different from the designed amount.

Further, in Comparative Example 2 in which a phosphorus-containing epoxy resin (polymerized composition of phosphaphenanthrene and a phenolic novolak epoxy resin (phosphorus concentration 2.2 wt%)) and a dicyandiamide curing agent were used, no reflow heat resistance was demonstrated. This was apparently because bonding of the dicyandiamide and phosphorus-containing epoxy was not sufficiently strong, thermal decomposition was caused by the heat applied during reflowing, and the generated volatile gases caused bulging.

In Comparative Example 3 that used the epoxy resin having components substantially identical to those of Example 1, except that the polymerized compound (A) in accordance with the present invention was not used, the test piece was completely burned in the burning test.

In Comparative Example 4, in which a polymerized compound (phosphorus concentration 2.2 wt%) of phosphaphenanthrene and a phenolic novolak epoxy same as that in Comparative Example 2 was combined with the curing agent (phenolic novolak curing agent) same as that of Examples 1 to 3, a high flame resistance (V-0 according to the UL standard) such as in Examples 1 to 3 could not be obtained.

Those results indicate that by using the epoxy resin composition including: (A) a polymerized compound including, as structural components, phosphaphenanthrene and at least one constituent selected from a structural unit of a phenolic novolak polymer and a structural unit of a phenolic novolak polymer in which a hydrogen atom of a phenolic hydroxyl group is substituted by phosphaphenanthrene; (B) an epoxy resin having two or more epoxy groups in a molecule; and (C) a curing agent that cures the epoxy resin, it is possible to obtain a prepreg, a metal-clad laminate, and a printed wiring board that excel in adhesiveness, soldering heat resistance, reflow heat resistance, and flame resistance.

### (Examples 7 to 11 not according to the invention and inventive examples 12 and 13)

Epoxy resin varnishes with a content of solids of 65 wt% to 75 wt% were prepared by adding methyl ethyl ketone and methoxypropanol to the compositions (parts by weight) shown in Table 2. Then, prepregs, copper-clad laminates, and printed wiring boards were obtained in the same manner as in Example 1.

The obtained prepregs, copper-clad laminates, and printed wiring boards were used as evaluation samples, and flame resistance (laminate), interlayer adhesion strength, heat resistance in PCT soldering, and reflow heat resistance were evaluated by the above-described methods. In addition, the ΔTg was evaluated by the below-described method. The results are shown in Table 2.

### [Evaluation of ΔTg]

The laminates of examples and comparative examples were held for 1 hour at 120°C as a pretreatment (to vaporize moisture contained in the laminate). The Tg of the pretreated laminates was measured under a nitrogen atmosphere by DSC on the basis of IPC TM650 2. 4. 25. The conditions were as follows:
- Weight of the laminate: 15 mg
- First measurement:
   The pretreated laminate was heated to 60°C and then from 60°C to 220°C at a temperature increase rate of 20°C/min, and the first glass transition temperature was measured (Tg₁).

The laminate was then cooled to 190°C and held for 15 min at 190°C.
- Second measurement:
   The laminate cooled to 60°C was heated from 60°C to 220°C at a temperature increase rate of 20°C/min, and the second glass transition temperature was measured (Tg₂).

The ΔTg is the difference between Tg₁ and Tg₂ (ΔTg = Tg₂ - Tg₁).

The value of ΔTg thus obtained can be used as an index for evaluating the degree of curing of the molded laminate. Since a large value of ΔTg indicates the presence of a large amount of unreacted components, the molded laminate in this case has inferior heat resistance and dimensional stability. Meanwhile, a small value of ΔTg means that the laminate has good heat resistance and dimensional stability.

**[Table 2]**

| Table 2 of Examples | | | | | | | | | |
|---|---|---|---|---|---|---|---|---|---|
| Contents | Trade name | Softening point | Example 7 | Example 8 | Example 9 | Example 10 | Example 11 | Example 12 | Example 13 |
| Polymerized compound of phosphaphenanthrene and phenolic novolak | EXB9150 | - | 15 | 15 | 15 | 15 | | 15 | 15 |
| | EXB9152 | | | | | | 15 | | |
| Cresol novolak epoxy | N690 | - | 40 | 40 | 40 | 40 | 40 | 40 | 40 |
| Bifunctional epoxy | 850S | - | 20 | 20 | 20 | 20 | 20 | 20 | 20 |
| Phenolic novolak curing agent | TD2093Y | 100 | | 25 | | | | | |
| | TD2131 | 80 | | | 25 | 25 | 25 | 12.5 | 2.5 |
| | TD2090 | 120 | 25 | | | | | 12.5 | 22.5 |
| Imidazole | 2E4MZ | - | 0.1 | 0.1 | 0.1 | 0.1 | 0.1 | 0.1 | 0.1 |
| Metallic soap | Zinc octanoate | - | | | | 1 | 1 | | |
| Phosphorus concentration | | | 1.6% | 1.6% | 1.6% | 1.6% | 1.6% | 1.6% | 1.6% |
| Flame resistance | | | 4 | 4 | 4 | 4 | 4 | 4 | 4 |
| Interlayer adhesiveness | | | 1.0 | 1.0 | 1.0 | 1.3 | 1.3 | 1.0 | 1.0 |
| Heat resistance in PCT soldering | | | 4hOK | 4hOK | 4hOK | 6hOK | 6hOK | 4hOK | 4hOK |
| Reflow heat resistance | | | Good | Good | Good | Good | Good | Good | Good |
| Tg-1st (DSC) | | | 124 | 133 | 128 | 133 | 135 | 128 | 127 |
| Tg-2nd (DSC) | | | 140 | 137 | 132 | 135 | 137 | 138 | 139 |
| ΔTg | | | 16.0 | 4.0 | 4.0 | 2.0 | 2.0 | 10 | 12 |

### (Results)

As shown in Table 2, where Example 7 in which the phenolic novolak curing agent with a softening point of 120°C is used is compared with Examples 8 to 11 in which the phenolic novolak curing agent with a softening point of 80°C or 100°C is used, in Examples 8 to 11 in which the phenolic novolak curing agent with a softening point equal to or lower than 105°C is used, a very small value of ΔTg can be obtained in addition to adhesiveness, soldering heat resistance, reflow heat resistance, and flame resistance. In other words, it is clear that by using the phenolic novolak curing agent with a softening point equal to or lower than 105°C, it is possible to obtain a substrate that has even better heat resistance and dimensional stability.

Comparing Example 7 with Examples 12 and 13 according to the invention, it is clear that by using the phenolic novolak curing agent with a softening point equal to or lower than 105°C in addition to the phenolic novolak curing agent with a softening point of 120°C, it is possible to decrease the ΔTg. Further, comparing Example 9 with Examples 12 and 13, it is clear that the Tg is higher in Examples 12 and 13 that use phenolic novolak curing agents of two types than in Example 9 in which the phenolic novolak curing agent with a low softening point is used. In other words, by using the phenolic novolak curing agent with a softening point of 120°C together with the phenolic novolak curing agent with a softening point equal to or lower than 105°C, it is possible to obtain a substrate with excellent Tg, heat resistance, and dimensional stability.

As described hereinabove, the epoxy resin composition in accordance with the present invention includes: (A) a polymerized compound including, as structural components, phosphaphenanthrene and at least one constituent selected from a structural unit of a phenolic novolak polymer and a structural unit of a phenolic novolak polymer in which a hydrogen atom of a phenolic hydroxyl group is substituted by phosphaphenanthrene; (B) an epoxy resin having two or more epoxy groups in a molecule; and (C) a curing agent that cures the epoxy resin, wherein the curing agent is a phenolic novolak curing agent with a softening point equal to or lower than 120°C; characterized in that a phenolic novolak curing agent with a softening point equal to or lower than 105°C and a phenolic novolak curing agent with a softening point of 105°C to 120°C are used together as the curing agent and by using such epoxy resin composition, it is possible to obtain a substrate that has high flame resistance and heat resistance.

Further, the curing agent is a phenolic novolak curing agent with a softening point equal to or lower than 120°C. The substrate molded using the epoxy resin of such a composition has a small ΔTg and even better heat resistance and dimensional stability.

Furthermore, where the curing agent is a phenolic novolak curing agent with a softening point equal to or lower than 105°C, the ΔTg is further reduced and therefore even better heat resistance and dimensional stability are obtained.

Where a phenolic novolak curing agent with a softening point equal to or lower than 105°C and a phenolic novolak curing agent with a softening point of 105°C to 120°C are used together as the curing agent, a substrate with balanced Tg and ΔTg can be obtained.

It is also preferred that an amine curing agent be used as the curing agent. The substrate molded using the epoxy resin of such a composition demonstrates better adhesion to a copper foil.

Further, the polymerized compound (A) in which the phosphaphenanthrene is 9,10-dihydro-9-oxa-10-phosphaphenanthrene-10-oxide (HCA) or a derivative thereof is preferred. When the polymerized compound (A) having such a phosphaphenanthrene structure is used, even higher flame resistance and heat resistance can be obtained.

The polymerized compound (A) is preferably represented by the said Chemical Formula (I). When the polymerized compound (A) having such a structure is used, even higher flame resistance and heat resistance can be obtained.

Furthermore, when a phosphorus concentration in the polymerized compound (A) is 10 wt% to 11 wt%, even higher flame resistance and heat resistance can be obtained.

It is preferred that the epoxy resin composition in accordance with the present invention further include an imidazole and a metal soap as curing accelerators, since even better effect in terms of adhesiveness and soldering heat resistance can be obtained.

It is also preferred that the epoxy resin composition in accordance with the present invention include 1 part by weight to 10 parts by weight of a condensed phosphoric acid ester as a flame retardant, since flame resistance is further increased, while maintaining the reflow heat resistance and adhesiveness.

The prepreg in accordance with the present invention is obtained by impregnating a fibrous substrate with the epoxy resin composition. By using such a prepreg, it is possible to obtain a metal-clad laminate and a printed wiring board having a heat resistance adequate for lead-free soldering and also a sufficient flame resistance even without containing a halogen flame retardant.

The metal-clad laminate in accordance with the present invention is obtained by laminating a metal foil on the prepreg and performing hot-press molding.

The printed wiring board in accordance with the present invention is obtained by partially removing the metal foil located on a surface of the metal-clad laminate to form a circuit.

## Claims

1. An epoxy resin composition, comprising:
(A) a polymerized compound including, as structural components, phosphaphenanthrene and at least one constituent selected from a structural unit of a phenolic novolak polymer and a structural unit of a phenolic novolak polymer in which a hydrogen atom of a phenolic hydroxyl group is substituted by phosphaphenanthrene;
(B) an epoxy resin having two or more epoxy groups in a molecule; and
(C) a curing agent that cures the epoxy resin, wherein the curing agent is a phenolic novolak curing agent with a softening point equal to or lower than 120°C;
**characterized in that**
a phenolic novolak curing agent with a softening point equal to or lower than 105°C and a phenolic novolak curing agent with a softening point of 105°C to 120°C are used together as the curing agent.

2. The epoxy resin composition according to claim 1, wherein the curing agent is a phenolic novolak curing agent with a softening point equal to or lower than 105°C.

3. The epoxy resin composition according to claim 1, wherein the curing agent is an amine curing agent.

4. The epoxy resin composition according to any one of claims 1 to 3, wherein the phosphaphenanthrene is 9,10-dihydro-9-oxa-10-phosphaphenanthrene-10-oxide or a derivative thereof.

5. The epoxy resin composition according to claim 4, wherein the polymerized compound (A) is a polymerized compound represented by Chemical Formula (I) below: 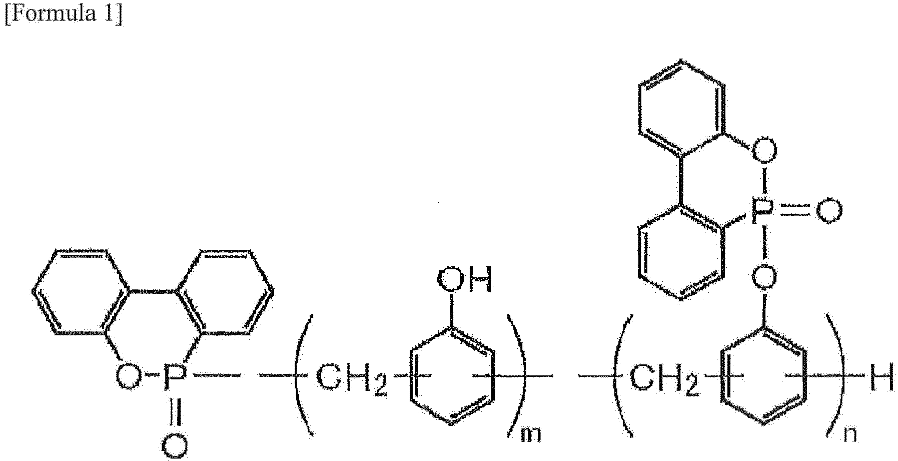 (in the formula, m is 0 to 3; n is 0 to 6; however, m and n are not 0 at the same time).

6. The epoxy resin composition according to any one of claims 1 to 5, wherein a phosphorus concentration in the polymerized compound (A) is 10 wt% to 11 wt%.

7. The epoxy resin composition according to any one of claims 1 to 6, further comprising an imidazole and a metal soap as curing accelerators.

8. The epoxy resin composition according to any one of claims 1 to 7, further comprising 1 part by weight to 10 parts by weight of a condensed phosphoric acid ester as a flame retardant.

9. A prepreg obtained by impregnating a fibrous substrate with the epoxy resin composition according to any one of claims 1 to 8.

10. A metal-clad laminate obtained by laminating a metal foil on the prepreg according to claim 9 and performing hot-press molding.

11. A printed wiring board obtained by partially removing the metal foil located on a surface of the metal-clad laminate according to claim 10 to form a circuit.

## Patentansprüche

1. Epoxidharzzusammensetzung, umfassend:
(A) eine polymerisierte Verbindung, die, als strukturelle Komponenten, Phosphaphenanthren und mindestens einen Bestandteil umfasst ausgewählt unter einer strukturellen Einheit eines phenolischen Novolak-Polymers und einer strukturellen Einheit eines phenolischen Novolak-Polymers, in dem ein Wasserstoffatom einer phenolischen Hydroxylgruppe durch Phosphaphenanthren substituiert ist;
(B) ein Epoxidharz, das zwei oder mehr Epoxygruppen in einem Molekül aufweist; und
(C) ein Aushärtungsmittel, das das Epoxidharz aushärtet, wobei das Aushärtungsmittel ein phenolisches Novolak-Aushärtungsmittel mit einem Erweichungspunkt gleich oder niedriger als 120 °C ist;
**dadurch gekennzeichnet, dass**
ein phenolisches Novolak-Aushärtungsmittel mit einem Erweichungspunkt gleich oder niedriger als 105 °C und ein phenolisches Novolak-Aushärtungsmittel mit einem Erweichungspunkt gleich oder niedriger als 105 °C bis 120 °C zusammen als Aushärtungsmittel verwendet werden.

2. Epoxidharzzusammensetzung nach Anspruch 1, wobei das Aushärtungsmittel ein phenolisches Novolak-Aushärtungsmittel mit einem Erweichungspunkt gleich oder niedriger als 105 °C ist.

3. Epoxidharzzusammensetzung nach Anspruch 1, wobei das Aushärtungsmittel ein Aminaushärtungsmittel ist.

4. Epoxidharzzusammensetzung nach irgendeinem der Ansprüche 1 bis 3, wobei das Phosphaphenanthren 9,10-Dihydro-9-oxa-10-phosphaphenanthren-10-oxid oder ein Derivat davon ist.

5. Epoxidharzzusammensetzung nach Anspruch 4, wobei die polymerisierte Verbindung (A) eine polymerisierte Verbindung ist, die durch die chemische Formel (I) unten dargestellt ist: 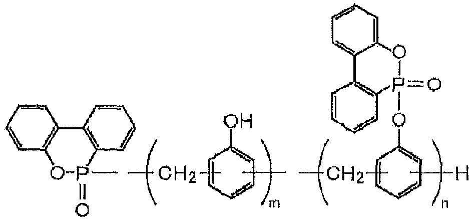 (in der Formel beträgt m 0 bis 3; n beträgt 0 bis 6; jedoch betragen m und n nicht gleichzeitig 0).

6. Epoxidharzzusammensetzung nach irgendeinem der Ansprüche 1 bis 5, wobei eine Phosphorkonzentration in der polymerisierten Verbindung (A) 10 Gew.-% bis 11 Gew.-% beträgt

7. Epoxidharzzusammensetzung nach irgendeinem der Ansprüche 1 bis 6, ferner ein Imidazol und eine Metallseife als Aushärtungsbeschleuniger umfassend.

8. Epoxidharzzusammensetzung nach irgendeinem der Ansprüche 1 bis 7, ferner 1 Gewichtsteil bis 10 Gewichtsteile eines kondensierten Phosphorsäureesters als Flammschutzmittel umfassend.

9. Prepreg, das durch Imprägnieren eines faserigen Substrats mit der Epoxidharzzusammensetzung nach irgendeinem der Ansprüche 1 bis 8 erhalten wird.

10. Metallverkleidetes Laminat, das durch Laminieren einer Metallfolie auf das Prepreg Anspruch 9 entsprechend und Ausführen von Heißpressformen erhalten wird.

11. Leiterplatte, die durch teilweises Entfernen der Metallfolie, die sich auf einer Oberfläche des metallverkleideten Laminats nach Anspruch 10 befindet, erhalten wird, um eine Schaltung zu bilden.

## Revendications

1. Composition de résine époxy comprenant :
(A) un composé polymérisé contenant, en tant que composants structurels, du phosphaphénanthrène et au moins un constituant choisi parmi un motif structurel d'un polymère novolaque phénolique et un motif structurel d'un polymère novolaque phénolique dans lequel un atome d'hydrogène d'un groupe hydroxyle phénolique est remplacé par du phosphaphénanthrène ;
(B) une résine époxy ayant deux ou plus de deux groupes époxy par molécule ; et
(C) un agent durcisseur qui durcit la résine époxy, lequel agent durcisseur est un agent durcisseur novolaque phénolique ayant un point de ramollissement égal ou inférieur à 120°C ;
**caractérisée en ce que**
un agent durcisseur novolaque phénolique ayant un point de ramollissement égal ou inférieur à 105°C et un agent durcisseur novolaque phénolique ayant un point de ramollissement de 105°C à 120°C sont utilisés conjointement en tant qu'agent durcisseur.

2. Composition de résine époxy selon la revendication 1, dans laquelle l'agent durcisseur est un agent durcisseur novolaque phénolique ayant un point de ramollissement égal ou inférieur à 105°C.

3. Composition de résine époxy selon la revendication 1, dans laquelle l'agent durcisseur est un agent durcisseur de type amine.

4. Composition de résine époxy selon l'une quelconque des revendications 1 à 3, dans laquelle le phosphaphénanthrène est le 10-oxyde de 9,10-dihydro-9-oxa-10-phosphaphénanthrène ou un dérivé de celui-ci.

5. Composition de résine époxy selon la revendication 4, dans laquelle le composé polymérisé (A) est un composé polymérisé représenté par la formule chimique (I) ci-dessous : 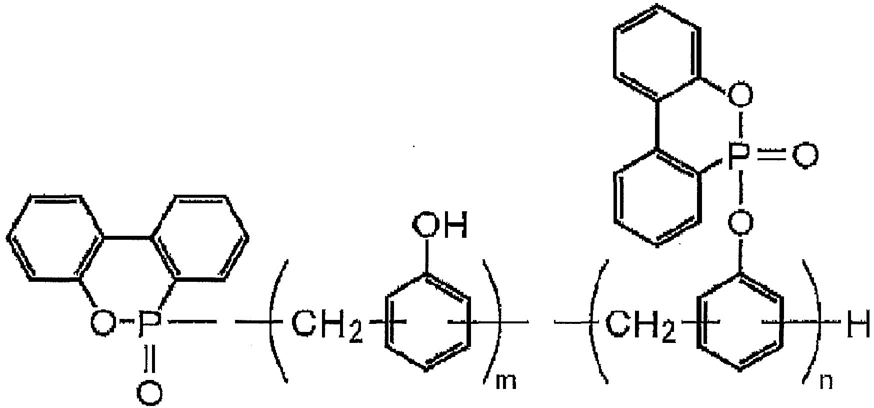 (dans la formule, m vaut de 0 à 3 ; n vaut de 0 à 6 ; toutefois, m et n ne valent pas 0 en même temps).

6. Composition de résine époxy selon l'une quelconque des revendications 1 à 5, dans laquelle la concentration de phosphore dans le composé polymérisé (A) est de 10 % en poids à 11 % en poids.

7. Composition de résine époxy selon l'une quelconque des revendications 1 à 6, comprenant en outre un imidazole et un savon métallique en tant qu'accélérateurs de durcissement.

8. Composition de résine époxy selon l'une quelconque des revendications 1 à 7, comprenant en outre de 1 partie en poids à 10 parties en poids d'un ester d'acide phosphorique condensé en tant que retardateur d'inflammation.

9. Préimprégné obtenu par imprégnation d'un substrat fibreux avec la composition de résine époxy selon l'une quelconque des revendications 1 à 8.

10. Stratifié plaqué de métal obtenu par stratification d'une feuille métallique sur le préimprégné selon la revendication 9 et mise en oeuvre d'un pressage à chaud.

11. Carte de circuit imprimé obtenu par élimination partielle de la feuille métallique située sur une surface du stratifié plaqué de métal selon la revendication 10 pour former un circuit.
